Europäisches Patentamt

European Patent Office

Office européen des brevets

(19)

(11) Veröffentlichungsnummer: **0 066 730**
**B1**

(12) **EUROPÄISCHE PATENTSCHRIFT**

(45) Veröffentlichungstag der Patentschrift:
**18.05.88**

(21) Anmeldenummer: **82104239.7**

(22) Anmeldetag: **14.05.82**

(51) Int. Cl.⁴: **H 01 L 21/28,** H 01 L 21/306,
H 01 L 21/316, H 01 L 29/78

(54) Gateisolations-Schichtstruktur, Verfahren zu ihrer Herstellung und ihre Verwendung.

(30) Priorität: **05.06.81 DE 3122382**

(43) Veröffentlichungstag der Anmeldung:
**15.12.82 Patentblatt 82/50**

(45) Bekanntmachung des Hinweises auf die Patenterteilung:
**18.05.88 Patentblatt 88/20**

(84) Benannte Vertragsstaaten:
**DE FR GB**

(56) Entgegenhaltungen:
DE-A-1 764 513
GB-A-1 400 780
US-A-3 665 265
US-A-3 730 766

THE BELL SYSTEM TECHNICAL JOURNAL, Band
54, Nr. 4, April 1975, Seiten 687-719, New York, USA
J.T. Clemens et al.: "Aluminium oxide/silicon
dioxide, double-insulator, MOS structure"
SOLID-STATE ELECTRONICS, Band 19, Nr. 3, 1976,
Seiten 181-189, Pergamon Press., Oxford, GB R.K.
Raymond et al.: "Fabrication and characteristics of
MOS-FET's incorporating anodic aluminum oxide in
the gate structure"

(73) Patentinhaber: **IBM DEUTSCHLAND GMBH,
Pascalstrasse 100, D-7000 Stuttgart 80 (DE)**
(84) Benannte Vertragsstaaten: **DE**

(73) Patentinhaber: **International Business Machines
Corporation, Old Orchard Road, Armonk, N.Y.
10504 (US)**
(84) Benannte Vertragsstaaten: **FR GB**

(72) Erfinder: **Gössler, Werner, Schwärzlingstrasse 19,
D-7033 Herrenberg (DE)**
Erfinder: **Strube, Anneliese, E 6 Essex Green
Greenfield Road, Essex Jet VT Burlington (US)**
Erfinder: **Zurheide, Manfred, Dipl.- Phys.,
Mainstrasse 34, D-7033 Herrenberg (DE)**

(74) Vertreter: **Oechssler, Dietrich, Dr. rer. nat., IBM
Deutschland GmbH Patentwesen und
Urheberrecht Schönaicher Strasse 220, D-7030
Böblingen (DE)**

# 0 066 730

**Beschreibung**

Die Erfindung betrifft eine Gateisolations-Schichtstruktur, welche von mindestens zwei auf einem Halbleitersubstrat aufgebrachten Schichten aus dielektrischem Material gebildet wird, wobei die auf der untersten dielektrischen Schicht aufliegende, zweite dielektrische Schicht Aluminiumoxid enthält, ein Verfahren zur Herstellung und die Verwendung einer solchen Gateisolations-Schichtstruktur.

Die Gateisolation bestimmt in starkem Maß die dielektrischen Parameter von Feldeffekttransistoren. Ein solcher wichtiger Parameter ist die sogenannte Schwellspannung $V_S$. Die $V_S$ ist beispielsweise bei Feldeffekttransistoren vom Anreicherungstyp diejenige kritische Gate-Source-Spannung, bei welcher sich gerade eine Inversionsschicht im Kanalgebiet ausbildet, bei der also - vom abgeschalteten Zustand ausgehend - gerade ein Drainstrom zu fließen beginnt. Einen wesentlichen Anteil zur $V_S$ liefert die sogenannte Flachbandspannung $V_{FB}$. Die $V_{FB}$ ist diejenige Spannung, welche bewirkt, daß die Energiebänder flach bis zur Kristalloberfläche verlaufen. Der genaueren Erläuterung dieses Sachverhalt dient das folgende Beispiel: Bei einer MOS-Struktur in der das Silicium P-leitend ist, rufen positive Ladungen $O_{ox}$ im Oxid und positiv (da wie die Dotierungsatome im Halbleiterkristall wirkend) ionisierte Oberflächenzustände $Q_{SS}$ eine Inversionsschicht hervor. Das elektrische Feld zwischen diesen positiven Ladungen und den negativen Raumladungen in der Inversionsschicht (Elektronen) bewirken eine Verbiegung der Bandkanten. Wird an die MOS-Struktur eine Gleichspannung gelegt, wobei der negative Pol am Metall und der positive am Silicium liegt, so wird die Metallschicht negativ aufgeladen. Die negative Ladung des Metalls treibt die Elektronen in der Inversionsschicht von der Siliciumoberfläche weg ins Siliciuminnere, wodurch die Bandverbiegung abnimmt. Wenn die negative Ladung in der Metallschicht gerade die positive Oxidladung $Q_{ox}$ sowie die positiv ionisierten Oberflächenzustände $Q_{SS}$ kompensiert, so verlaufen die Energiebänder flach zur Kristalloberfläche. Die dann am MOS-Kondensator anliegende Vorspannung ist die Flachbandspannung die ein Maß für $Q_{ox}$ und $Q_{SS}$ ist. Über eine Änderung der $V_{FB}$ läst sich $V_S$ verändern. Der Wert von $V_S$ muß beispielsweise bei N-Kanal-Feldeffekttransistoren vom Anreicherungstyp in der Größenordnung von 1 Volt liegen. Liegt $V_S$ wesentlich unter diesem Wert, so schaltet der Transistor nicht mehr sicher ab. Auftretende Leckströme im abgeschalteten Zustand beeinträchtigen stark die Funktion von monolithischen Speicherschaltkreisen. Der Wert von $V_S$ darf andererseits auch nicht zu groß sein, da hohe Spannungspegel im Betrieb die Wärmeentwicklung und die Verlustleistung im Chip bestimmen und außerdem zeitverzögernd auf die Signale wirken. Sind in einer integrierten Schaltung beispielsweise einem Speicherschaltkreis mehrere solcher Feldeffekttransistoren hintereinander geschaltet, so ist die Einstellung der richtigen $V_S$ noch kritischer. Es besteht nämlich in diesem Fall nicht nur die Gefahr, daß bei zu niedriger $V_S$ die Feldeffekttransistoren nicht mehr zumachen sondern auch daß bei zu hohem $V_S$ die Feldeffekttransistoren nicht mehr aufmachen. Es ist also wichtig, über Mittel zu verfügen, um $V_S$ innerhalb eines relativ kleinen Spannungsbereich definiert und reproduzierbar zu variieren.

Zur Beeinflussung der Höhe von $V_S$ (und auch ihrer Stabilität) ist es bekannt, die Dicke der Gate-Isolationsschicht und die Dotierung des Halbleitersubstrats im Gatebereich zu variieren und die positiven Ladungen im Oxid zu beeinflussen, indem das Oxid möglichst bald durch eine weitere Schicht aus dielektrischem Material, beispielsweise aus $Si_3N_4$ oder Phosphorsilicatglas abgedeckt wird.

Aus den Artikeln von D.R. Young u.a. im Journal of Electron Materials, Band 6, Nr. 5, 1977, Seite 569 ff. und im IBM Journal of Research and Development, Band 22, Nr. 3, Mai 1978, Seite 285 ff. ist es auch bekannt, durch Einbringen von Aluminium mittels Ionenimplantation in das Oxid einer MOS (Metall-Oxid-Silicium)-Struktur das $V_{FB}$ zu erhöhen. Die Erhöhung der $V_{FB}$ wird dabei auf ein Einfangen von Elektronen in Fallen zurückgeführt, welche sich als Folge der durch die Ionenimplantation hervorgerufenen Kristallfehlern bilden. Es ist auch so, daß als Folge der Ionenimplantation eine untolerierbare Instabilität der Schwellspannung $V_S$ unter den Bedingungen, welchen die Feldeffekttransistoren, die eine solche Struktur enthalten, im Betrieb ausgesetzt sind, auftritt.

In der DAS 1 764 513 ist die Erniedrigung von $V_S$ bei einem Feldeffekt-Halbleitersteuerelement beschrieben, in dem statt einer $SiO_2$-Schicht eine aus einer $SiO_2$-Schicht und einer darüberliegenden, 30 bis 100 nm dicken Aluminiumoxid-Schicht bestehende Schichtstruktur verwendet wird, wobei durch Variation der $SiO_2$-Schichtdicke $V_S$ in einem weiten Bereich verändert werden kann. Es ist bei der Struktur unausbleiblich, daß durch den Übergang von der nur aus $SiO_2$ bestehenden Gateisolation zu der oben genannten Gateisolationsstruktur die dielektrischen Eigenschaften der Struktur beachtlich geändert werden.

Es ist die Aufgabe der Erfindung, eine Gateisolations-Schichtstruktur, die mit einer definierten, innerhalb eines festgelegten Spannungsbereiches liegenden Schwellspannung erzeugt werden kann, wobei die Instabilität der Schwellspannung unter Streßbelastung unterhalb des als noch tolerierbar angesehenen Maximalwerts liegt, ein einfaches Verfahren zur reproduzierbaren Herstellung einer solchen Struktur und Verwendungsmöglichkeiten für sie anzugeben.

Diese Aufgabe wird mit einer Gateisolations-Schichtstruktur der eingangs genannten Art mit dem Merkmal des kennzeichnenden Teils des Anspruch 1, einem Verfahren der eingangs genannten Art mit den Merkmalen des kennzeichnenden Teils des Patentanspruchs 5 und einer Verwendung gemäß dem Gegenstand des Patentanspruchs 8 gelöst. ·

Es ist überraschend, daß bei der erfindungsgemäßen Struktur auch mit nichtimplantiertem Aluminium, d.h. mit Aliminium, welches nicht unter Erzeugung von Kristallschäden eingebracht worden ist, sich die Schwellspannung definiert einstellen läßt, und zwar ohne daß unter Streßbedingungen eine nennenswerte Instabilität der Schwellspannung festgestellt wird. Die günstigen Wirkungen stellen sich ein, ohne daß die

2

Dotierung des Halbleitermaterials im Gatebereich erhöht oder die dielektrischen Eigenschaften der Isolationsstruktur verändert werden müssen. Eine Erhöhung der Dotierung, wie z. B. einer Bor-Dotierung im Gatebereich, fördert die Bildung von sogenannten "heißen Elektronen", welche eine Instabilität der Schwellspannung verursachen, d.h. zu einer allmählichen Verschiebung der Schwellspannung im Betrieb (LITS, Leakage Induced Threshold Shift) führt. Eine Änderung der dielektrischen Eigenschaften der Gateisolation hat eine Änderung der Steilheit $\lambda_n$ (transconductance) des zugehörigen Feldeffekttransistors zur Folge.

Es ist vorteilhaft, wenn als Substrat ein Siliciumkörper verwendet wird, und die unterste Schicht aus $SiO_2$, die darüberliegende Schicht außer aus Aluminiumoxid aus $SiO_2$ und die gegebenenfalls vorhandene weitere Schicht aus $Si_3N_4$ hergestellt werden. In vorteilhafter Weise läßt sich eine aus diesen Materialien bestehende Struktur erzeugen, indem die Siliciumoberfläche mit einer Wasser, Wasserstoffperoxid, Ammoniak und eine festgeiegte Menge einer Aluminiumverbindung enthaltenden Lösung gereinigt wird, indem anschließend in an sich bekannter Weise thermisch oxidiert und dann das $Si_3N_4$ pyrolytisch niedergeschlagen wird.

Das erfindungsgemäße Verfahren ist außerdem einfach und liefert nicht nur reproduzierbare Ergebnisse, sondern erfordert auch keinen größeren apparativen und zeitlichen Aufwand als die bekannten Verfahren.

Die erfindungsgemäße Struktur wird vorteilhaft insbesondere in N-Kanal-Feldeffekttransistoren vom Anreicherungstyp eingesetzt. N-Kanal-Feldeffekttransistoren haben gegenüber P-Kanal-Feldeffekttransistoren beachtliche Vorteile, wie eine größere Steilheit, einen kleineren Widerstand und die einfachere Herstellung. Für hochintegrierte dichtgepackte (LSI = Large Scale Integration) Halbleiterschaltungen kommen nur Feldeffekttransistoren vom Anreicherungstyp in Frage, die dabei in großer Anzahl auf einem gemeinsamen Halbleitersubstrat integriert werden.

Weitere vorteilhafte Ausgestaltungen der Erfindung ergeben sich aus den Unteransprüchen.

Die Erfindung wird anhand von durch Zeichnungen erläuterten Ausführungsbeispielen beschrieben. Es zeigen

Fign. 1A bis 1C eine Gateisolations-Schichtstruktur in drei Stadien ihrer Herstellung gemäß einer bevorzugten Ausführungsform des erfindungsgemäßen Verfahrens,

Fig. 2 in einem Diagramm die Erhöhung der Schwellspannung V aufgetragen gegen den Aluminiumgehalt in der bei der bevorzugten Ausführungsform des erfindungsgemäßen Verfahrens verwendeten Reinigungslösung und

Fig. 3 in einem Diagramm die Veränderung der Schwellspannung, $\Delta V_S$, unter Streßbedingungen in Abhängigkeit vom Aluminiumgehalt in der bei der bevorzugten Ausführungsform des erfindungsgemäßen Verfahrens benutzten Reinigungslösung.

Im folgenden wird die Erzeugung einer Gateisolations-Schichtstruktur gemäß einer Ausführungsform des erfindungsgemäßen Verfahrens im Zusammenhang mit der Herstellung eines N-Kanal-Feldeffekttransistors vom Anreicherungstyp anhand der Fign. 1A bis 1C besprochen. Es sei aber klargestellt, daß die Erfindung nicht auf die Erzeugung von Gateisolationsstrukturen für N-Kanal-Feldeffekttransistoren vom Anreicherungstyp und auf die Verwendung des unten angegebenen Halbleitermaterials und die unten angegebenen Schichtmaterialien beschränkt ist.

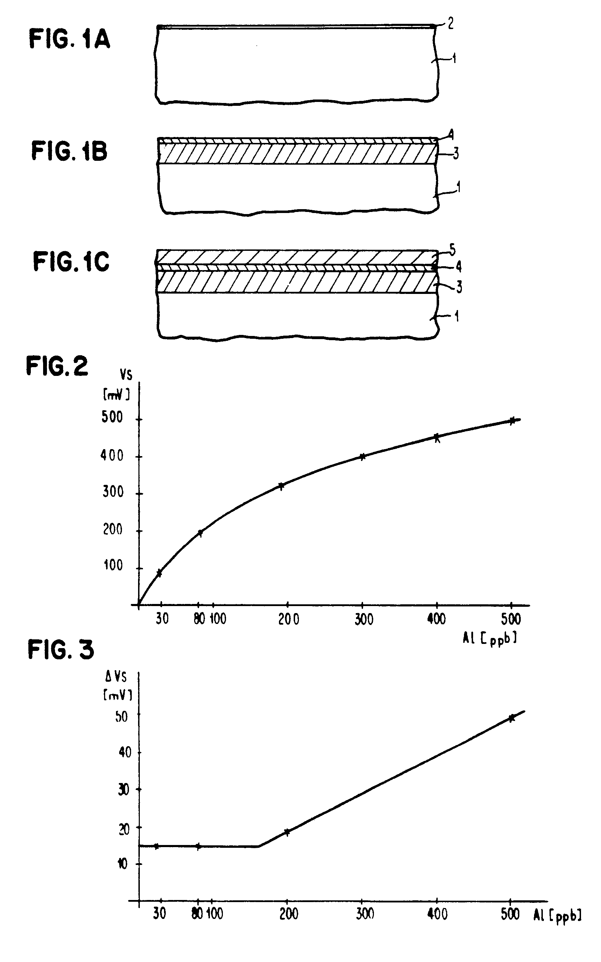

Ausgegangen wird von einem Siliciumsubstrat vom P-Typ. Die Herstellung der N-dotierten Drain- und Source Bereiche erfolgt auf konventionellem Weg es wird deshalb und da die Herstellung der Drain- und Source Bereiche für die Erfindung nicht wesentlich ist, darauf nicht näher eingegangen. Das Siliciumsubstrat 1, welches mindestens im Bereich des herzustellenden Gates freiliegt, wird mit einer basischen Wasser, Wasserstoffperoxid, Ammoniak und eine Aluminiumverbindung wie z. B. Aluminiumchlorid enthaltenden Lösung gereinigt. Typischerweise enthält die Reinigungslösung Wasser, Wasserstoffperoxid (30,5-%-ige Lösung) und Ammoniak (27,5-%-ige Lösung) im Volumenverhältnis von ungefähr 5 : 1 : 1 und eine so große Menge der Aluminiumverbindung, daß der Gewichtsanteil an Aluminium in der Lösung zwischen ungefähr 20 und 400 ppb (Gewichtsteile pro $10^9$ Gewichtsteile aller Bestandteile zusammengenommen) liegt. Bei der Behandlung mit der Lösung wird nicht nur die Siliciumoberfläche gereinigt sondern auch, da die Reinigungslösung basisch ist, Aluminium an der Siliciumoberfläche angelagert. Versuche haben ergeben, daß bei einem Gehalt der Reinigungslösung von ungefähr 400 ppb Aluminium nach der Reinigung auf der Siliciumoberfläche eine Aluminiummenge von ungefähr 250 pg/cm$^2$ Siliciumoberfläche abgeschieden worden ist. Ist der Aluminiumgehalt in der Lösung geringer, so wird auch entsprechend weniger Aluminium auf dem Silicium abgeschieden. Andererseits ist zu beachten, daß bei einer weiteren Erhöhung des Aluminiumgehalts der Lösung sich die abgeschiedene Aluminiummenge nicht entsprechend weiter erhöht sondern daß die abgeschiedene Aluminiummenge offenbar einem Sättigungswert zustrebt. Das Ergebnis der Reinigung zeigt schematisch die Fig. 1A, in welcher die dünne Aluminiumschicht mit der Nr. 2 bezeichnet ist. Im Anschluß an die Reinigung wird das Siliciumsubstrat 1 bei Temperaturen im Bereich zwischen etwa 900 und etwa 1100°C in einer im wesentlichen Sauerstoff enthaltenden Atmosphäre oxidiert, wobei eine zwischen etwa 25 und etwa 40 nm dicke Siliciumdioxidschicht aufgewachsen wird. Das Aluminium in der Schicht 2 wird nicht in das Siliciumdioxid eingebaut, sondern hält sich in der Nähe der Oberfläche der aufwachsenden Schicht 3 und wird außerdem seinerseits oxidiert. Als Ergebnis der Oxidation, welches die Fig. 1B wiedergibt, entsteht also außer der Siliciumdioxidschicht 3 eine auf dieser aufliegende ungefähr 1 bis ungefähr 1,5 nm dicke Schicht 4 welche aus Aluminiumoxid und Siliciumdioxid besteht. ·

Die Aluminiumoxid enthaltende Schicht 4 läßt sich auch noch auf andere Weise, beispielsweise durch ein pyrolytisches Niederschlagen eines aus $Al_2O_3$ und $SiO_2$ bestehenden Gemischs erzeugen, jedoch ist das oben beschriebene Verfahren wesentlich einfacher, da der apparative und zeitliche Aufwand geringer ist und die richtige Dosierung des Aluminiums leichter einstellbar ist.

Im nächsten Verfahrensschritt erfolgt das Abscheiden einer Siliciumnitridschicht 5 auf der dünnen, Aluminiumoxid enthaltenden Schicht 4. Die Siliciumnitridschicht schützt das darunterliegende $SiO_2$ bei Ätzprozessen, bei denen $SiO_2$ angegriffen wird. Am einfachsten läßt sich die Siliciumnitridschicht 5 pyrolytisch erzeugen, beispielsweise indem bei ungefähr 925°C die bis dahin erzeugte Struktur einen Silan, Ammoniak und Wasserstoff (als Trägergas) enthaltenden Gemisch ausgesetzt wird. Bevorzugt ist die Siliciumnitridschicht 5 zwischen ungefähr 10 und ungefähr 15 nm dick. Die nun vorliegende Struktur zeigt schematisch die Fig. 1C. Das Siliciumnitrid hat insbesondere den Zweck die Gateoxidschicht 3 vor dem Eindringen von positiv geladenen Ionen zu schützen.

Die jetzt noch fehlenden Verfahrensschritte bis zur Vollendung des Feldeffekttransistors, nämlich Herstellung der Kontaktlöcher, der Kontakte und der Leiterzugverbindungen erfolgt wiederum entsprechend bekannter Verfahren und hat mit der Erfindung nicht unmittelbar etwas zu tun. Deshalb soll auf diese Verfahrensschritte nicht näher eingegangen werden.

Das Vorhandensein der Alumniumoxid enthaltenden Schicht 4 in der Isolationsschichtstruktur bewirkt, daß je nach dem Aluminiumgehalt der Schicht die Schwellspannung $V_S$ des eine solche Struktur enthaltende Feldeffekttransistors um ungefähr 80 bis ungefähr 470 Millivolt höher liegt als bei Feldeffekttransistoren, welche keine Schicht 4 enthalten. Dabei steigt die Schwellspannung $V_S$ mit zunehmenden Aluminiumgehalt in der Schicht 4 an. Die Wirkung des Aluminiums beruht offenbar darauf, daß sein Einbau die Erzeugung von negativen Ladungen in der Siliciumdioxidschicht 3 bewirkt.

Vorteilhaft wird das erfindungsgemäße Verfahren auch bei der Herstellung von Feldeffekttransistoren eingesetzt, welche nicht wie der Feldeffekttransistor dessen Herstellung oben beschrieben worden ist, eine MNOS (Metall-Nitrid-Oxid-Silicium-Struktur), sondern eine MONOS-Sturktur aufweisen, das heißt Feldeffekttransistoren bei welchen zwischen der Metall und der Nitridschicht sich noch eine Siliciumdioxidschicht findet. Diese zusätzliche Siliciumdioxidschicht wird entweder dadurch hergestellt, daß vor dem Aufbringen des Leiterzugmaterials entweder eine Oberflächenschicht der Siliciumnitridschicht 5 durch thermische Oxidation in Siliciumdioxid umgewandelt wird oder in dem auf die Siliciumnitridschicht 5 eine dünne Schicht aus polykristallinem Silicium aufgebracht und anschließend vollständig durch thermische Oxidation in Siliciumdioxid umgewandelt wird. Die MONOS-Struktur hat gegenüber 1 der MNOS-Struktur den Vorteil, daß Elektronen, welche aus dem als Leitermaterial dienenden Aluminium stammen an der Grenzfläche zwischen der zusätzlichen $SiO_2$-Schicht und der Siliciumnitridschicht festgehalten werden, während sie beim Fehlen der zusätzlichen Siliciumdioxidschicht durch das Nitrid hindurchwandern. Diese Elektronenwanderung hat eine gewisse Instabilität der Schwellspannung unter Streßbedingungen (siehe unten) zur Folge. Feldeffekttransistoren mit MONOS-Struktur haben deshalb im Betrieb eine stabilere Schwellspannung als die Feldeffekttransistoren mit MNOS-Struktur während sich die beiden Typen in ihren sonstigen elektrischen Eigenschaften nicht voneinander unterscheiden.

Die folgenden sieben Beispiele sollen das erfindungsgemäße Verfahren noch mehr verdeutlichen. Es sei dabei klargestellt, daß die gestellte Aufgabe auch dann gelöst werden kann, wenn das erfindungsgemäße Verfahren unter anderen Bedingungen als in den Beispielen angegeben ist, durchgeführt wird.

Bei allen Beispielen werden N-Kanal-Feldeffekttransistoren vom Anreicherungstyp, welche eine MONOS-Struktur aufweisen hergestellt. Unterschiedlich bei den Beispielen ist lediglich die Aluminiummenge, welche in die dünne Aluminiumoxid enthaltende Schicht zwischen der ersten Siliciumdioxid- und der Siliciumnitridschicht eingebaut wird. Zunächst wird das P-dotierte und N-dotierte Source- und Drainbereiche enthaltende Siliciumsubstrat, wie oben angegeben, mit einer Lösung gereinigt, welche Wasser, Wasserstoffperoxid und Ammoniak im Volumenverhältnis von 5 : 1 : 1 und außerdem eine festgelegte Menge einer Aluminiumverbindung enthält. Anschließend wird bei 1000°C in einer Atmosphare, welche 97 Vol.-% Sauerstoff und 3 Vol.-% HCl enthält solange oxidiert, bis eine ungefähr 31 nm dicke Siliciumdioxidschicht aufgewachsen ist. Dabei bildet sich auf der Siliciumdioxidschicht eine ungefähr 1 nm dicke Aluminiumoxid und Siliciumdioxid enthaltende Schicht. Im nächsten Verfahrensschritt wird pyrolytisch eine ungefähr 20 nm dicke Siliciumnitridschicht auf der Aluminium enthaltenden Schicht abgeschieden, indem die Struktur bei 925°C einem Silan, Ammoniak und Wasserstoff als Trägergas im Volumenverhältnis von ungefähr 1 : 150 : 18000 enthaltenden Gasgemisch ausgesetzt wird. Daraufhin wird die Siliciumnitridschicht oberflächlich solange thermisch bei 1075°C in einer Sauerstoff/Wasserdampf-Atmosphäre erhitzt, bis sich auf der Siliciumnitridschicht eine ungefähr 7 nm dicke Siliciumdioxidschicht gebildet hat. Nach dem Öffnen der Kontaktlöcher wird eine ungefähr 650 nm dicke Aluminiumschicht aufgedampft und schließlich wird in bekannter Weise auf photolithographischem Weg das Leiterzugnetz erzeugt.

In der Tabelle sind die Aluminiummengen, welche die Reinigungslösungen bei den 7 Beispielen enthalten und außerdem die bei den einzelnen Beispielen erzielten Anhebungen der Schwellspannung $V_S$ und die Verschiebung der Schwellspannung $\triangle V_S$ welche unter Streßbedingungen in Folge des Aluminiumeinbaus in Kauf genommen werden müssen, aufgelistet.

**TABELLE**

| Beispiel Nr. | Menge Al in Reinigungs-lösung [ppb] | $V_S$-Anhebung [(mV)] | $\Delta V_S$ (unter Streßbe-dingungen) [mV] |
|---|---|---|---|
| 1 | 0 | 0 | 15 |
| 2 | 30 | 100 | 15 |
| 3 | 80 | 200 | 15 |
| 4 | 200 | 350 | <20 |
| 5 | 300 | 420 | - |
| 6 | 400 | 470 | - |
| 7 | 500 | 500 | 50 |

$\Delta V_S$ wird in der Weise ermittelt, daß die Struktur einer Temperatur von 100°C ausgesetzt wird und gleichzeitig 10 Minuten lang zwischen Gate und Source eine Spannung von 17 Volt gelegt wird. $\Delta V_S$ wird aus der Differenz zwischen der zu Beginn und am Ende der Streßbelastung gemessenen $V_S$-Werte ermittelt. Aus den Fign. 2 und 3 in welchen die in der Tabelle aufgeführten $V_S$- bzw. die $\Delta V_S$-Werte gegen die zugehörigen Aluminiummengen in der Reinigungslösung aufgetragen sind, ergibt sich, daß, wenn man keine durch das Aluminium verursachte Instabilität der Schwellspannung zuläßt, der Reinigungslösung bis so ungefähr 160 (Gewichts-) ppb zugemischt werden dürfen, wodurch eine Erhöhung der Schwellspannung $V_S$ von ungefähr 300 mV erreicht wird. Wenn man eine Instabilität der Schwellspannung $V_S$ von bis zu 40 mV zuläßt, was auch bei sehr hohen Anforderungen immer noch als sehr gute Stabilität anzusehen ist, so können, wie das Diagramm in der Fig. 3 zeigt, bis zu etwa 400 ppb Aluminium der Reinigungslösung zugesetzt werden umd man erreicht dadurch - wie das Diagramm in der Fig. 2 zeigt - eine $V_S$-Erhöhung von ungefähr 470 mV. Mit dem erfindungsgemäßen Verfahren läßt sich also die Schwellspannung $V_S$ von Feldeffekttransistoren innerhalb eines relativ großen Bereichs definiert und reproduzierbar verändern.

Die gemäß dem erfindungsgemäßen Verfahren hergestellten Strukturen finden insbesondere in N-Kanal-Feldeffekttransistoren vom Anreicherungstyp Anwendung, welche in großer Zahl und hintereinandergeschaltet auf Halbleitersubstraten in hoher Dichte integriert sind.

Zusammenfassend läßt sich sagen, daß das erfindungsgemäße Verfahren im Rahmen der Herstellung von Feldeffekttransistoren angewandt wird und bevorzugt so durchgeführt wird, daß auf der Oberfläche eines P-dotierten Siliciumsubstrats beispielsweise mittels einer basischen, Aluminium enthaltenden Reinigungslösung Aluminium abgeschieden wird, anschließend thermisch oxidiert wird, wobei sich außer dem Oxid eine ungefähr 1 bis 1,5 nm dicke Aluminiumoxid und Siliciumdioxid enthaltende Schicht bildet und schließlich - sofern erwünscht - noch mindestens eine weitere Schicht beispielsweise eine $Si_3N_4$ oder eine $Si_3N_4$- und eine $SiO_2$-Schicht aufgebracht werden. Durch einen Zusatz von ungefähr 400 ppb zu der Reinigungslösung was einer Al-Menge in der fertigen Struktur von ungefahr 250 pg/cm$^2$ Schichtoberfläche gleichzusetzen ist, kann die Schwellspannung $V_S$ um ungefähr 470 Millivolt angehoben werden, wobei eine Instabilität der Schwellspannung $\Delta V$ unter Streßbedingungen in der Größenordnung von 40 Millivolt in Kauf genommen werden muß.

**Patentansprüche**

1. Gateisolations-Schichtstruktur, welche von mindestens zwei auf einem Halbleitersubstrat (1) aufgebrachten Schichten aus dielektrischem Material gebildet wird, wobei die auf der untersten dielektrischen Schicht (3) aufliegende, zweite elektrische Schicht (4) Aluminiumoxid enthält,
dadurch gekennzeichnet,
daß die Aluminiumoxid enthaltende Schicht (4) aus einer Mischung von Aluminiumoxid und einem weiteren dielektrischen Material besteht und zwischen 1 und ungefähr 1,5 nm dick ist und der Aluminiumgehalt auf einen Wert unter ungefahr 250 pg/cm$^2$ Schichtfläche eingestellt ist.

2. Schichtstruktur nach Anspruch 1,
dadurch gekennzeichnet,
daß auf die Aluminiumoxid enthaltende Schicht (3) noch mindestens eine weitere elektrische Schicht aufgebracht ist.

3. Schichtstruktur nach Anspruch 1 oder 2,
dadurch gekennzeichnet,
daß als Substrat (1) ein Siliciumkörper vorgegeben ist und die unterste Schicht (3) aus $SiO_2$ besteht, die Aluminiumoxid enthaltende Schicht (4) auch $SiO_2$ enthält, die erste weitere Schicht (5) aus $Si_3N_4$ und die zweite weitere Schicht aus $SiO_2$ bestehen.

4. Schichtstruktur nach einem oder mehreren der Ansprüche 1 bis 3,
dadurch gekennzeichnet,
daß die SiO$_2$-Schicht (3) zwischen etwa 25 und 40 nm, die Si$_3$N$_4$-Schicht (5) zwischen etwa 10 und 15 nm und die auf der Si$_3$N$_4$-Schicht aufliegende SiO$_2$-Schicht zwischen etwa 5 und 10 nm dick sind.

5. Verfahren zum Herstellen einer Gateisolations-Schichtstruktur nach einem der Ansprüche 1 bis 4,
dadurch gekennzeichnet,
daß die Oberfläche eines Siliciumsubstrats (1) mit einer Wasser, Wasserstoffperoxid, Ammoniak und eine Aluminiumverbindung enthaltenden basischen Lösung gereinigt wird, wobei der Gehalt der Aluminiumverbindung in der Lösung so hoch ist, daß bei der nachfolgenden Oxidation eine Oberflächenschicht entsteht, deren Aluminiumgehalt kleiner als ungefähr 250 pg/cm$^2$ Schichtfläche ist, daß anschließend in an sich bekannter Weise thermisch oxidiert, daraufhin - sofern erwünscht - Si$_3$N$_4$ pyrolytisch aufgebracht und gegebenenfalls eine weitere SiO$_2$-Schicht durch Oxidation einer dünnen Oberflächenschicht des Si$_3$N$_4$ oder durch Aufbringen einer dünnen Polysiliciumschicht und deren anschließende vollständige Oxidation erzeugt wird.

6. Verfahren nach Anspruch 5,
dadurch gekennzeichnet,
daß der Reinigungslösung je nach der angestrebten V$_S$-Anhebung zwischen etwa 20 und etwa 400 Gewichtsppb Aluminium in Form einer Aluminiumverbindung zugemischt wird.

7. Verfahren nach Anspruch 6,
dadurch gekennzeichnet,
daß eine Reinigungslösung verwendet wird, in der Wasser, Wasserstoffperoxid (30,5-%-igen Lösung) und Ammoniak (27,5-%-ige Lösung) im Volumenverhältnis 5 : 1 : 1 enthalten sind, daß bei einer Temperatur von ungefähr 65°C gereinigt wird und die Oxidation bei ungefähr 1000°C in einer Gasatmosphäre durchgeführt wird, welche 97 Vol.% Sauerstoff und 3 % HCl enthält.

8. Verwendung der Gateisolations-Schichtstruktur nach einem der Ansprüche 1 bis 4 in einem N-Kanal-Feldeffekttransistor vom Anreicherungstyp.

9. Verwendung nach Patentanspruch 8 in einer Reihe von N-Kanal-Feldeffekttransistoren vom Anreicherungstyp, welche in einer integrierten Schaltung hintereinander geschaltet sind.

## Claims

1. Gate insulation layer structure formed by at least two layers of dielectric material which are deposited on a semiconductor substrate (1), wherein the second dielectric layer (4), overlying the bottom-most dielectric layer (3) 1 contains aluminium oxide,
characterized in that the layer (4), containing aluminium oxide, consists of a mixture of aluminium oxide and a further dielectric material and is about 1.5 nm thick, and the aluminium content is set to a value of less than about 250 pg/cm$^2$ of the layer surface.

2. Layer structure according to claim 1,
characterized in that at least one further dielectric layer is deposited on the layer (3) containing aluminium oxide.

3. Layer structure according to claim 1 or 2,
characterized in that a silicon body is used as a substrate (1) and the bottom-most layer (3) consists of SiO$_2$, the layer (4), containing aluminium oxide, also contains SiO$_2$, the first further layer (5) consists of Si$_3$N$_4$ and the second further layer of SiO$_2$.

4. Layer structure according to any one or combination of claims 1 to 3,
characterized in that the SiO$_2$ layer (3) is between about 25 and 40 nm thick, the Si$_3$N$_4$ layer (5) is between about 10 and 15 nm thick, and the SiO$_2$ layer, overlying the Si$_3$N$_4$ layer, is between about 5 and 10 nm thick.

5. Method of producing a gate insulation layer structure according to any one of the claims 1 to 4,
characterized in that the surface of the silicon substrate (1) is cleaned by means of a basic solution containing water, hydrogen peroxide, ammonia and an aluminium compound, the content of the aluminium compound in the solution being so high that during the subsequent oxidation a surface layer is obtained, whose aluminium content is less than about 250 pg/cm$^2$ of the layer surface, this being followed by thermal oxidation which is effected in a manner known per se, subsequently, if desired, pyrolytically depositing Si$_3$N$_4$, and optionally generating a further SiO$_2$ layer by oxidizing a thin surface layer of the Si$_3$N$_4$ or by depositing and then completely oxidizing a thin polysilicon layer.

6. Method according to claim 5,
characterized in that, depending upon the desired V$_S$ increase, between about 20 and about 400 ppb by weight aluminium in the form of an aluminium compound are added to the cleaning solution.

7. Method according to claim 6,
characterized in that a cleaning solution is used which contains water, hydrogen peroxide (30.5 per cent solution) and ammonia (27. 5 per cent solution) at a volume ratio of 5 : 1 : 1, that cleaning is effected at about 65°C and oxidation at about 1000°C in a gas atmosphere containing 97 per cent by volume oxygen and 3 per cent HCl.

8. Use of the gate insulation layer structure according to any one of the claims 1 to 4 in an N-channel field-effect transistor of the enhancement type.

9. Use according to patent claim 8 in a number of N-channel field-effect transistors of the enhancement type which are connected in series in an integrated circuit.

## Revendications

1. Structure à couches d'isolant de grille, qui est formée par au moins deux couches déposées sur un substrat semiconducteur (1) et constituées en un matériau diélectrique, la seconde couche diélectrique (4), qui est déposée sur la couche diélectrique inférieure (3), contenant de l'oxyde d'aluminium, caractérisée en ce que la couche (4) contenant de l'oxyde d'aluminium est constituée par un mélange d'oxyde d'aluminium et d'un autre matériau diélectrique et possède une épaisseur comprise entre 1 et environ 1,5 nm et que la teneur en aluminium est réglée à une valeur voisine de 250 pg/cm$^2$ de surface de la couche.

2. Structure à couche selon la revendication 1, caractérisée en ce qu'en outre au moins une couche supplémentaire diélectrique est déposée sur la couche (3) contenant de l'oxyde d'aluminum.

3. Structure à couches selon la revendication 1 ou 2, caractérisée en ce qu'un corps en silicium est prévu en tant que substrat (1) et que la couche inférieure (3) est constituée en $SiO_2$, que la couche (4) contenant de l'oxyde d'aluminium contient également du $SiO_2$, que la première couche supplémentaire (5) est constituée par du $Si_3N_4$ et que la seconde couche supplémentaire est constituée par du $SiO_2$.

4. Structure à couches selon une ou plusieurs des revendications 1 à 3, caractéarisée en ce que la couche (3) de $SiO_2$ possède une épaisseur comprise entre environ 25 et 40 nm, que la couche (5) de $Si_3N_4$ possède une épaisseur comprise entre environ 10 et 15 nm et que la couche de $SiO_2$ déposée sur la couche de $Si_3N_4$ possède une épaisseur comprise entre environ 5 et 10 nm.

5. Procédé pour fabriquer une structure à couches d'isolation de grille selon l'une des revendications 1 à 4, caractérisé en ce qu'on nettoie la surface d'un substrat en silicium (1) avec une solution basique contenant de l'eau, de l'eau oxygénée, de l'ammoniaque et un composé d'aluminium, la teneur du composé d'aluminium dans la solution étant suffisamment élevée pour que lors de l'oxydation ultérieure, il apparaisse une couche superficielle dont la teneur en aluminium est inférieure à environ 250 pg/cm$^2$ de la surface de la couche, qu'on oxyde ensuite la surface du substrat en silicium par voie thermique, d'une manière connue en soi, qu'on dépose ensuite - dans la mesure où cela est souhaitable - du $Si_3N_4$ par voie pyrolytique et qu'on forme éventuellement une couche supplémentaire de $SiO_2$ par oxydation d'une couche superficielle mince du $Si_3N_4$ ou par dépôt d'une mince couche de polysilicium et oxydation complète ultérieure de cette couche.

6. Procédé selon la revendication 5, caractérisé en ce qu'on ajoute en mélange à la solution de nettoyage, en fonction de l'accroissement recherché de $V_S$, entre environ 20 et environ 400 ppb en poids d'aluminium sous la forme d'un composé d'aluminium.

7. Procédé selon la revendication 6, caractérisé en ce qu'on utilise une solution de nettoyage qui contient de l'eau, de l'eau oxygénée (solution à 30,5 %) et de l'ammoniaque (solution à 27,5 %) dans les rapports volumiques 5 : 1 : 1, qu'on effectue le nettoyage à une température d'environ 65°C et qu'on réalise l'oxydation à environ 1000°C dans une atmosphère de gaz, qui contient 97 % en volume d'oxygène et 3 % de HCl.

8. Utilisation de la structure à couches d'isolation de grille selon l'une des revendications 1 à 4 dans un transistor à effet de champ à canal N du type à enrichissement.

9. Utilisation selon la revendication 8 dans une série de transistors à effet de champ à canal N du type à enrichissement, qui sont branchés en série dans un circuit intégré.

FIG. 1A

FIG. 1B

FIG.1C

FIG.2

FIG. 3